# EUROPEAN PATENT APPLICATION

(11) **EP 4 415 064 A1**
(43) Date of publication of application: **14.08.2024**
(21) Application number: 22895235.4
(22) Date of filing: 21.09.2022
(51) Int. Cl.: H01L 33/58, H01L 33/50

(54) **SEMICONDUCTOR LIGHT EMITTING DEVICE AND SEMICONDUCTOR LIGHT EMITTING MODULE**

(30) Priority: 22.11.2021 JP 2021189685
(71) Applicant: Stanley Electric Co. Ltd., Tokyo 153-8636 (JP)
(72) Inventor: KONO, Keima, Tokyo 153-8636 (JP); ICHIKAWA, Koji, Tokyo 153-8636 (JP); KAMBARA, Daizo, Tokyo 153-8636 (JP); HORIO, Naochika, Tokyo 153-8636 (JP)
(74) Representative: Pritzlaff, Stefanie Lydia
(86) International application number: PCT/JP2022/035167
(87) International publication number: WO 2023/089949

(57) **Abstract**

A semiconductor light emitting device includes: a wiring substrate on which a p-electrode and an n-electrode are provided on a substrate; a light-emitting functional layer including a p-type semiconductor layer and an n-type semiconductor layer connected to the p-electrode and the n-electrode, respectively, and bonded onto the wiring substrate; a light-transmitting optical element having a light shielding film provided on a side surface of a plate-shaped light-transmitting optical body and which has an annular frame portion that covers a peripheral edge portion of a back surface of the light-transmitting optical body and formed on the peripheral edge portion; and an adhesive layer configured to adhere the light-transmitting optical element to an upper surface of the wiring substrate such that the light-emitting functional layer is inserted into a recessed portion inside the frame portion. The recessed portion is filled with the adhesive layer.

## Description

### Technical Field

The present invention relates to a semiconductor light emitting device and a semiconductor light emitting module, and more specifically, to a semiconductor light emitting device having semiconductor light emitting elements such as light emitting diodes (LEDs) and semiconductor light emitting modules.

### Background Art

In recent years, semiconductor light emitting elements such as light emitting diodes (LEDs) are disposed and used in a plurality of devices in order to increase an output or control light distribution.

For example, among vehicle headlights, an adaptive driving beam (ADB) that controls light distribution according to a traveling environment is known. In addition, an LED package for high-output illumination, an LED package for an information communication device in which LEDs are disposed at high density, or the like is known.

However, in a semiconductor light emitting device in which a plurality of semiconductor light emitting elements is arranged side by side, a part of light emitted from a conductive element may generally propagate through a non-conductive element. Such leakage light or crosstalk of light arises as a problem in various application fields in which the plurality of semiconductor light emitting elements is disposed and used.

For example, Patent Literature 1 discloses a semiconductor light emitting device in which side surfaces of a substrate and a light emitting element are covered with a light reflection layer by using an atomic layer deposition method. In addition, Patent Literature 2 discloses a light emitting element including a reflection member that covers a side surface of a semiconductor laminate, in which the reflection member has a first insulator film and a second insulator film including a dielectric multilayer film (distributed Bragg reflector (DBR)).

Patent Literature 3 discloses a light emitting device including a light transmission member, a light emitting element bonded to the light transmission member, and a light guide member extending from a surface of the light emitting element to a surface of the light transmission member.

Patent Literature 4 discloses a light emitting device including a light emitting element, a light transmission member, and a cover member that contains a light reflective material and covers at least a side surface of the light transmission member.

### Citation List

### Patent Literatures

Patent Literature 1: Japanese Patent Application Laid-Open No. 2015-225862
Patent Literature 2: Japanese Patent Application Laid-Open No. 2015-119063
Patent Literature 3: Japanese Patent Application Laid-Open No. 2010-219324
Patent Literature 4: Japanese Patent No. 2010-219324

### Summary of Invention

### Technical Problem

In the conventional light emitting device described above, a coating film is provided on side surfaces of a wavelength conversion member and a light emitting element, or a light guide member is provided on the side surfaces of the wavelength conversion member and the light emitting element. In such a light emitting device, the coating film on the side surface of the light emitting element or a side surface of a bonding portion between the light emitting element and the wavelength conversion member may be peeled off or cracked due to heating during mounting of the light emitting device, thermal history under a usage environment, or the like.

The present invention has been made in view of the above-described point, and an object of the present invention is to provide a light emitting device having high light shielding characteristics of emitted light from a light emitting element and emitted light from a wavelength conversion member and having excellent reliability without providing a separate cover member on a side surface of the light emitting element.

Another object of the present invention is to provide a light emitting module in which a plurality of light emitting devices can be mounted close to each other and in contact with each other, light shielding between the light emitting devices is excellent, crosstalk is suppressed, and reliability is excellent.

### Solution to Problem

A semiconductor light emitting device according to one embodiment of the present invention including: a wiring substrate on which a p-electrode and an n-electrode are provided on a substrate; a light-emitting functional layer including a p-type semiconductor layer connected to the p-electrode, a light emitting layer, and an n-type semiconductor layer connected to the n-electrode, and bonded onto the wiring substrate; a light-transmitting optical element having a light shielding film provided on a side surface of a plate-shaped light-transmitting optical body and which has an annular frame portion that covers a peripheral edge portion of a back surface of the light-transmitting optical body and formed on the peripheral edge portion; and an adhesive layer configured to adhere the light-transmitting optical element to an upper surface of the wiring substrate such that the light-emitting functional layer is inserted into a recessed portion inside the frame portion, in which the recessed portion is filled with the adhesive layer.

A semiconductor light emitting module according to another embodiment of the present invention including: a plurality of the semiconductor light emitting devices, in which two of the semiconductor light emitting devices are provided such that side surfaces of the light-transmitting optical elements are disposed adjacent to each other.

A semiconductor light emitting module according to still another embodiment of the present invention including: a plurality of the semiconductor light emitting devices; and a plurality of series connection systems, in which each of the series connection systems includes two of the semiconductor light emitting devices having side surfaces of the light-transmitting optical elements disposed adjacent to each other and connected in series.

A semiconductor light emitting module according to still another embodiment of the present invention including: a plurality of the semiconductor light emitting devices; and two series connection systems connected in series, respectively, in which four semiconductor light emitting devices are arranged in a 2 × 2 matrix, and one pair of the semiconductor light emitting devices disposed at a diagonal position and the other pair of the semiconductor light emitting devices disposed at a diagonal position.

### Brief Description of Drawings

FIG. 1A is a top view schematically illustrating an upper surface of a semiconductor light emitting device 10 according to a first embodiment of the present invention.
FIG. 1B is a cross-sectional view illustrating a cross section taken along the line A-A of FIG. 1A.
FIG. 1C is an exploded cross-sectional view illustrating a configuration of the semiconductor light emitting device 10, which corresponds to FIG. 1B.
FIG. 2 is a plan view schematically illustrating a back surface of the semiconductor light emitting device 10.
FIG. 3A is an SEM image showing a cross section of an example of a light shielding film 55.
FIG. 3B is an SEM image showing an upper end portion and a rim portion 55R of the light shielding film 55 in an enlarged manner.
FIG. 3C is an SEM image showing a cross section of the light shielding film 55 according to another example.
FIG. 4A is a graph showing a film thickness of each layer of a dielectric multilayer film of the light shielding film 55.
FIG. 4B is a graph showing a wavelength dependence of a reflectance of the light shielding film 55 having the dielectric multilayer film.
FIG. 5A is a top view illustrating an example of a structure of an LED 11.
FIG. 5B is a cross-sectional view illustrating a cross section taken along the line A-A illustrated in FIG. 5A.
FIG. 6A is a top view (upper part) and a side view (lower part) illustrating a semiconductor light emitting module 60 according to a second embodiment of the present invention.
FIG. 6B is a perspective view illustrating an example of a mounting form of the semiconductor light emitting module 60.
FIG. 7A is a plan view (upper part) illustrating an internal configuration of the semiconductor light emitting module 60 and a cross-sectional view (lower part) illustrating a cross section taken along the line A-A illustrated in the plan view.
FIG. 7B is a plan view schematically illustrating wirings (upper and lower parts) of two wiring layers of a module substrate 61.
FIG. 8A is a top view (upper part) and a side view (lower part) illustrating an internal structure of a semiconductor light emitting module 70 according to a third embodiment of the present invention.
FIG. 8B is a cross-sectional view schematically illustrating a cross section taken along the line A-A illustrated in FIG. 8A.
FIG. 9A is a top view illustrating a semiconductor light emitting module 80 according to a fourth embodiment of the present invention.
FIG. 9B is a plan view (upper part) illustrating an internal structure of the semiconductor light emitting module 80 and a cross-sectional view (lower part) illustrating a cross section taken along the line A-A illustrated in the plan view.
FIG. 9C is a plan view schematically illustrating wirings of an upper wiring layer 81A and a buried wiring layer 81B of the module substrate 81.
FIG. 10A is a view schematically illustrating a connection form of semiconductor light emitting devices 10A1 and 10A2.
FIG. 10B is a view schematically illustrating a connection form of semiconductor light emitting devices 10B1 and 10B2.

### Description of Embodiments

While the present invention is described below in terms of the presently preferred embodiments, appropriate modifications or combinations thereof may be applied. In addition, in the following description and the appended drawings, parts which are substantially identical or equivalent have been assigned identical reference symbols in the description.

### [First Embodiment]

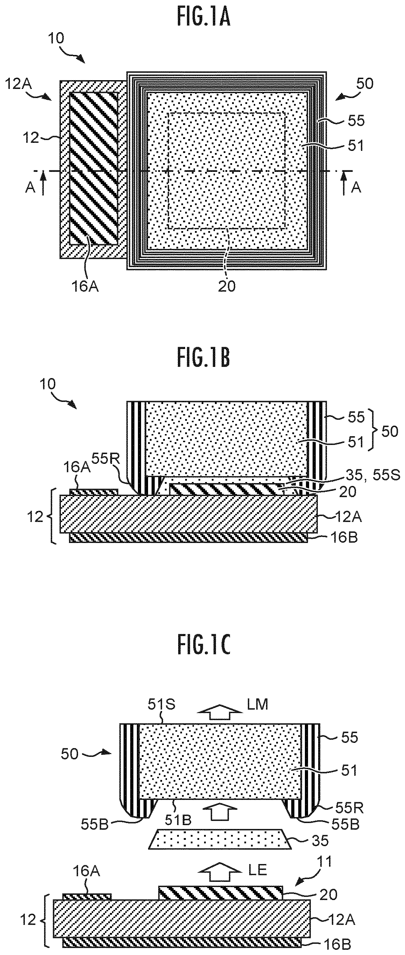

FIG. 1A is a top view schematically illustrating an upper surface of a semiconductor light emitting device 10 according to a first embodiment of the present invention. FIG. 1B is a cross-sectional view illustrating a cross section taken along the line A-A of FIG. 1A. In addition, FIG. 1C is an exploded cross-sectional view illustrating a configuration of the semiconductor light emitting device 10, which corresponds to FIG. 1B.

As illustrated in FIGS. 1A, 1B, and 1C, the semiconductor light emitting device 10 includes an LED (light emitting diode) 11, which is a light emitting element, and a wavelength conversion element 50, which is a light-transmitting optical element. The wavelength conversion element 50 is adhered to the LED 11 by a light-transmitting adhesive layer 35.

As illustrated in FIG. 1C, the LED 11 includes a wiring substrate (submount) 12 and a light-emitting functional layer 20. The wiring substrate 12 includes a support substrate 12A, a light-emitting functional layer 20 formed on the support substrate 12A, and an anode 16A and a cathode 16B. Emitted light LE is emitted from the LED 11. The support substrate 12A is, for example, silicon (Si), and is opaque to the emitted light from the LED 11.

The light-emitting functional layer 20 has a p-type semiconductor, an n-type semiconductor layer, and a light emitting layer provided between the p-type semiconductor layer and the n-type semiconductor layer. The light-emitting functional layer 20 may include a p-electrode and an n-electrode. For example, a reflective electrode may be provided on a bottom surface side of the light-emitting functional layer 20, or a reflective layer may be provided. Alternatively, the light-emitting functional layer 20 may be bonded to the support substrate 12A by a reflective bonding member. In addition, the light-emitting functional layer 20 is electrically connected to the anode 16A and the cathode 16B of the support substrate 12A.

The wavelength conversion element 50 includes a plate-shaped wavelength conversion body 51 and a light shielding film 55 provided on a side surface of the wavelength conversion body 51. In the present embodiment, the light shielding film 55 is provided over the entire side surface of the wavelength conversion body 51. However, the light shielding film 55 may be provided on at least a part of the side surface of the wavelength conversion body 51, that is, a side surface portion to be shielded.

In the following description, the wavelength conversion element 50 has been described as an example of the light-transmitting optical element provided on the LED 11, but the present invention is not limited thereto. The light-transmitting optical element 50 including a light-transmitting optical body 51, instead of the wavelength conversion body 51, and a light shielding film 55 provided on a side surface of the light-transmitting optical body 51 can be applied.

Moreover, in the present embodiment, a case in which the wavelength conversion element 50 has a rectangular shape will be described as an example. However, the shape of the wavelength conversion element 50 is not limited thereto. For example, the wavelength conversion element 50 may have a shape such as a polygonal shape or a cylindrical shape (including an elliptical cylindrical shape).

As illustrated in FIG. 1C, the emitted light LE emitted from the light-emitting functional layer 20 of the LED 11 is transmitted through the adhesive layer 35 and is incident on the wavelength conversion body 51 from a back surface 51B of the wavelength conversion body 51 (that is, a surface close to the light-emitting functional layer 20).

The emitted light LE of the LED 11 is, for example, blue light. A part of the emitted light LE of the LED 11 is wavelength-converted into, for example, yellow light when passing through the wavelength conversion body 51. Then, the wavelength conversion body 51 emits white light, which is mixed color light of the yellow light and the blue light transmitted through the wavelength conversion body 51, from an upper surface S1S of the wavelength conversion body 51 (emitted light LM).

The emitted light LE of the LED 11 is not limited to blue light, and may be light in a visible light range, such as red light and green light, light outside the visible light range, such as ultraviolet light and infrared light, or the like.

The light shielding film 55 is formed to cover a peripheral edge portion of the back surface 51B of the wavelength conversion body 51, and has a frame portion (hereinafter, referred to as a rim portion) 55R that protrudes from the back surface 51B. That is, the rim portion 55R is formed on the peripheral edge portion of the back surface 51B of the wavelength conversion body 51 as a rectangular annular frame.

As illustrated in FIG. 1B, a bottom portion 55B of the annular rim portion 55R of the light shielding film 55 is adhered by the adhesive layer 35 so as to be in contact with an upper surface of the wiring substrate 12 of the LED 11. That is, the light-emitting functional layer 20 is inserted into a recessed portion 55S formed inside the rim portion 55R, and the recessed portion 55S is filled with the adhesive layer 35.

The rim portion 55R may be not in contact with the upper surface of the wiring substrate 12, and a gap may be provided between the bottom portion 55B of the rim portion 55R and the upper surface of the wiring substrate 12. Even in this case, the light-emitting functional layer 20 is buried in the adhesive layer 35. It is preferable that at least a part of the rim portion 55R is in contact with the upper surface of the wiring substrate 12. In addition, from the viewpoint of light shielding properties, it is most preferable that the entire rim portion 55R is in contact with the upper surface of the wiring substrate 12.

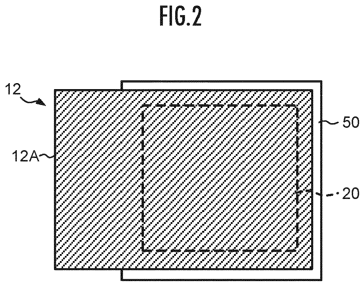

FIG. 2 is a plan view schematically illustrating a back surface of the semiconductor light emitting device 10. In the present embodiment, the wavelength conversion element 50 is provided on the wiring substrate 12 such that three side surfaces of the wavelength conversion element 50 protrude from the wiring substrate 12.

In a case of a light emitting module in which a plurality of the semiconductor light emitting devices 10 is disposed adjacent to or in contact with each other, it is preferable that at least one side surface or a part of the side surface of the wavelength conversion element 50 protrudes from the side surface of the wiring substrate 12. In a case where the wavelength conversion element 50 has a rectangular column shape, it is most preferable that three side surfaces of the wavelength conversion element 50 protrude from the side surfaces of the wiring substrate 12. For example, since the wiring substrates 12 of adjacent light emitting devices 10 are spaced apart from each other by a portion of the wavelength conversion element 50 protruding from the side surface of the substrate 12, the wiring substrate 12 is not short-circuited.

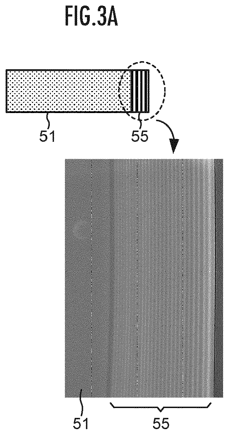

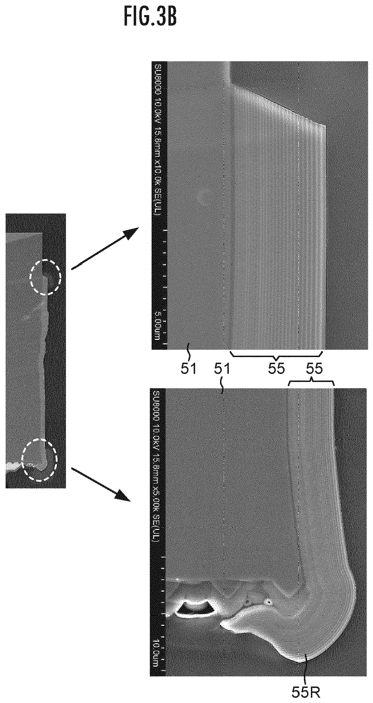

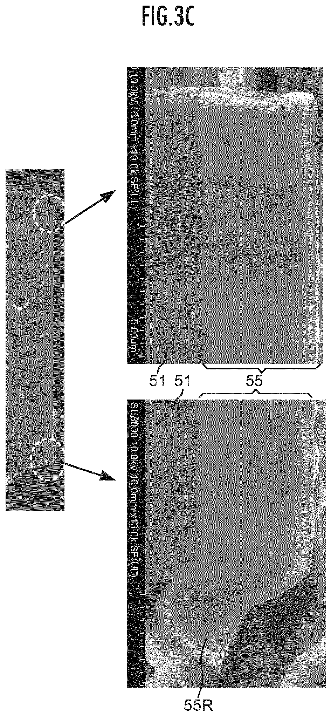

FIG. 3A is a scanning electron microscope (SEM) image showing a cross section of an example of the light shielding film 55. FIG. 3B is an SEM image showing an upper end portion and a rim portion 55R of the light shielding film 55 in an enlarged manner. In addition, FIG. 3C is an SEM image showing a cross section of the light shielding film 55 according to another example.

In this case, the light shielding film 55 was formed of a dielectric multilayer film in which an Al₂O₃ film and a TiO₂ film were alternately laminated. The light shielding film 55 was formed by an atomic layer epitaxy (ALE) method using a molecular beam epitaxy (MBE) device. In addition, the film can also be formed by an atomic layer deposition (ALD) method.

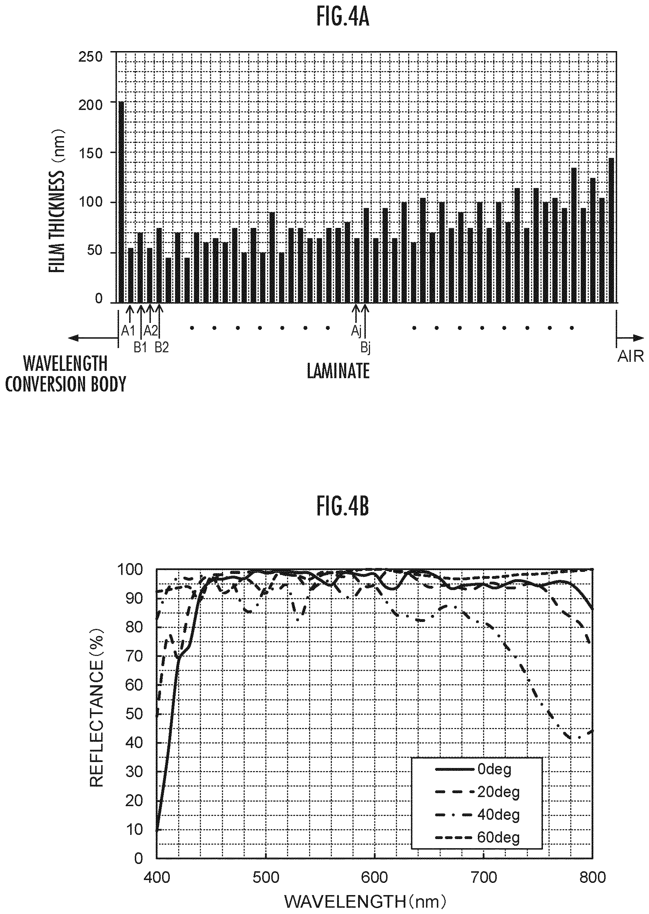

FIG. 4A is a graph showing a film thickness of each layer of the dielectric multilayer film of the light shielding film 55. A thick layer (200 nm) serving as an underlying layer was formed, and Al₂O₃ films (Aj: j = 1, 2, ...) and TiO₂ films (Bj: j = 1, 2, ...) which functioned as a reflective film were alternately laminated thereon to form a dielectric multilayer film. The film thickness of each of the Al₂O₃ film and the TiO₂ film was changed such that the angle dependence of the light shielding characteristics in the wavelength range of light incident on the light shielding film 55 was reduced. That is, a multilayer film including an Al₂O₃ film and a TiO₂ film, in which the film thickness was modulated with respect to the film thickness corresponding to λ/4 (λ: wavelength in a medium), was adopted. The total thickness of the light shielding film 55 was 4.7 µm.

FIG. 4B illustrates a result of calculation of the wavelength dependence of the reflectance of the light shielding film 55 having the dielectric multilayer film described above, using the light incidence angle as a parameter. It is understood that a high reflectance with a low angle dependence is obtained in the visible light region.

The light shielding film 55 may be formed using a dielectric multilayer film in which the Al₂O₃ film and the TiO₂ film, each having a film thickness corresponding to λ/4, are alternately laminated.

Referring to FIG. 3A, it can be seen that the light shielding film 55 having a flat and uniform layer structure is firmly attached to and formed on a flat side surface of the wavelength conversion body 51. In addition, as illustrated in FIG. 3B, it was confirmed that the light shielding film 55 also had a flat and uniform layer structure at the upper end portion of the light shielding film 55. In addition, it was confirmed that the light shielding film 55 was formed to ride on the peripheral edge portion of the bottom surface of the wavelength conversion body 51, and that the rim portion 55R including a multilayer film was formed on a lower end portion of the light shielding film 55.

FIG. 3C is an SEM image showing a cross section of the light shielding film 55 according to another example. As in FIG. 3B, FIG. 3C illustrates an SEM image in which the upper end portion of the light shielding film 55 and the rim portion 55R are enlarged. In the light shielding film 55 of the other example, the side surface of the wavelength conversion body 51 has a wavy unevenness, and the flatness of the side surface is lower than that of the wavelength conversion body 51 illustrated in FIG. 3B. However, it can be seen that the light shielding film 55 is firmly attached to and formed on the side surface of the wavelength conversion body 51. In addition, the light shielding film 55 sufficiently functions as a light shielding film even in a case where the layer structure of the light shielding film 55 has some ripples. Further, it was confirmed that the rim portion 55R including a multilayer film was formed on the lower end portion of the light shielding film 55.

With such a configuration, among the light emitted from the light-emitting functional layer 20 of the LED 11, the light emitted in a lateral direction (horizontal direction) of the light-emitting functional layer 20 is shielded by the rim portion 55R, and the emission of the light to the outside is prevented. In addition, the light guided inside the wavelength conversion body 51 is also shielded by the light shielding film 55. Therefore, in the semiconductor light emitting device 10, the light is emitted only from the upper surface S1S of the wavelength conversion body 51 (emitted light LM).

Moreover, the light-emitting functional layer 20 is protected by the wiring substrate 12 and the wavelength conversion element 50. In addition, the light-emitting functional layer 20 is hermetically sealed with the adhesive layer 35.

The light shielding film 55 can be formed of, for example, a dielectric multilayer film or a light-shielding ceramic film. As the dielectric multilayer film used in the light shielding film 55, for example, a multilayer film including two or more of Al₂O₃, TiO₂, SiO₂, Ta₂O₅, or Nb₂O₅ can be used, but the present invention is not limited thereto, and a light-shielding or reflective multilayer film in which various films are alternately laminated can be used.

Alternatively, in a case in which a ceramic film is used as the light shielding film 55, for example, a film formed of alumina, zirconia, aluminum nitride, or silicon nitride can be used.

Moreover, as a base material of the wavelength conversion body 51, alumina, glass, aluminous garnet, or the like can be used, and as a phosphor, YAG:Ce, GYAG:Ce, LuAG:Ce, α-sialon, β-sialon, CASN, SCASN, or the like can be used.

As described above, in the semiconductor light emitting device 10, the wavelength conversion element 50 having a size slightly larger than a size of the light-emitting functional layer 20 is adhered to the LED 11. In addition, an electrode to which power is supplied to the LED 11 is provided on an upper surface and/or a lower surface of the support substrate 12A. Therefore, it is possible to realize the semiconductor light emitting device 10 having a size slightly larger than that of the wavelength conversion element 50 and having high light shielding properties in which the emission of light to the side is prevented.

### [Structure of LED 11]

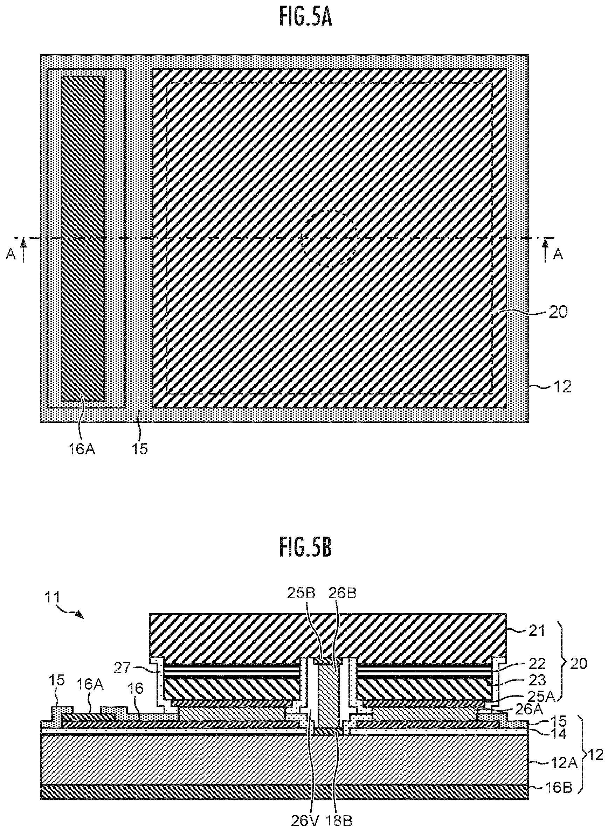

FIG. 5A is a top view illustrating an example of the structure of the LED 11, and FIG. 5B is a cross-sectional view illustrating a cross section taken along the line A-A in FIG. 5A.

A so-called thin-film LED layer is used as the light-emitting functional layer 20. More specifically, the light-emitting functional layer 20 has a configuration in which a semiconductor laminate (thin-film LED) having an LED structure epitaxially grown on a growth substrate is removed from the growth substrate. The removed light-emitting functional layer 20 is bonded to the wiring substrate 12.

More specifically, the light-emitting functional layer 20 includes an n-type semiconductor layer 21, a light emitting layer 22, and a p-type semiconductor layer 23. In addition, the light-emitting functional layer 20 includes a reflective p-electrode 25A provided on the p-type semiconductor layer 23 and an n-electrode 25B provided on the n-type semiconductor layer 21.

As the reflective p-electrode 25A, for example, an ITO/Ni/Pt/Ag layer in which a light-transmitting conductive film of indium tin oxide (ITO), a nickel (Ni) film, a platinum (Pt) film, and a silver (Ag) reflective film are formed on the p-type semiconductor layer 23 in this order can be used. In addition, as the n-electrode 25B, a Ti/Au layer in which Ti (titanium) and Au (gold) are formed on the n-type semiconductor layer 21 in this order can be used.

The materials and structures of the p-electrode 25A and the n-electrode 25B are not limited to the above-described ones. The materials and structures thereof can be appropriately selected in consideration of characteristics such as extraction efficiency improvement by light reflection, ohmic characteristics, and element reliability (lifespan).

The light-emitting functional layer 20 has a via 26V reaching from a surface of the p-type semiconductor layer 23 to the inside of the n-type semiconductor layer 21 at the center of the light-emitting functional layer 20. The n-electrode 25B is provided on the n-type semiconductor layer 21 exposed to the via 26V. An inner wall of the via 26V and the side surface of the light-emitting functional layer 20 are covered with a protective film 27.

Each of the n-type semiconductor layer 21 and the p-type semiconductor layer 23 is formed of at least one semiconductor layer, and may have various semiconductor layers such as a barrier layer, a current diffusion layer, and a contact layer according to a design such as improved characteristics.

The wiring substrate 12 includes the conductive support substrate 12A, and the anode 16A and the cathode 16B formed on a front surface and a back surface of the support substrate 12A, respectively. Si, which is an n-type semiconductor, is used as the support substrate 12A.

More specifically, an interlayer insulating film 14 formed of SiO₂ is formed on the support substrate 12A. A p-wiring electrode 16 is formed on the interlayer insulating film 14. The p-wiring electrode 16 is covered with a substrate protective film 15 which is an insulating film and formed of SiO₂. As illustrated in FIG. 5A, FIG. 1A, and FIG. 1B, the substrate protective film 15 has an opening on an outside of a region on which the wavelength conversion element 50 is placed, and the anode 16A, which is a pad electrode provided on the p-wiring electrode 16, is exposed from the opening. That is, the anode 16A is provided on the upper surface of the wiring substrate 12 that protrudes from a mounting region of the wavelength conversion element 50.

Moreover, the substrate protective film 15 has a rectangular opening corresponding to the p-electrode 25A on the bottom surface of the light-emitting functional layer 20, and the p-wiring electrode 16 is exposed from the rectangular opening and is bonded to the p-electrode 25A of the light-emitting functional layer 20.

Further, the substrate protective film 15 has a circular opening corresponding to the via 26V of the light-emitting functional layer 20. The support substrate 12A is exposed from the circular opening, and an n-wiring electrode 18B, which is an ohmic electrode, is formed on the exposed portion.

The p-electrode 25A of the light-emitting functional layer 20 is bonded to the p-wiring electrode 16 of the wiring substrate 12 by a bonding layer 26A. In addition, the n-electrode 25B of the light-emitting functional layer 20 is bonded to the n-wiring electrode 18B on the support substrate 12A by a bonding layer 26B. That is, the light-emitting functional layer 20 includes a p-electrode and an n-electrode on a bottom surface side of the light-emitting functional layer 20, and is mounted on the wiring substrate 12 in a so-called p-side down.

### [Second Embodiment]

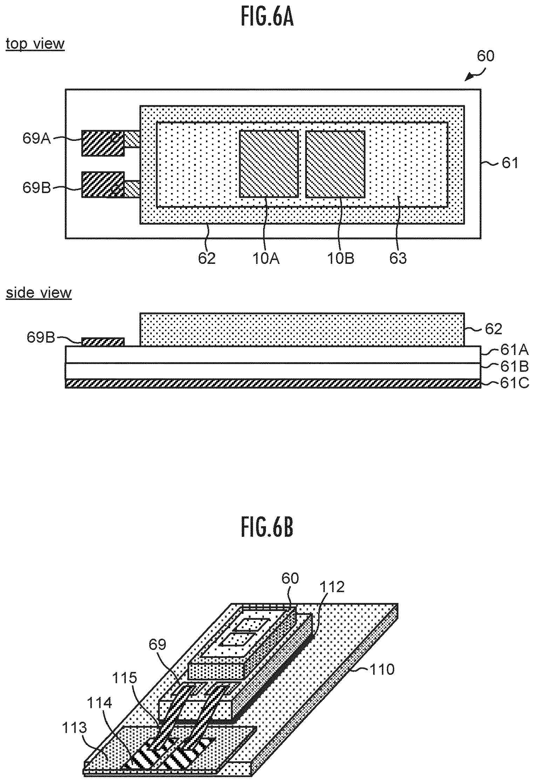

FIG. 6A is a top view (upper part) and a side view (lower part) illustrating a semiconductor light emitting module 60 according to a second embodiment of the present invention.

The semiconductor light emitting module 60 includes a module substrate 61 which is a low temperature co-fired ceramics (LTCC) multilayer ceramic substrate, and two semiconductor light emitting devices 10A and 10B having the same structure as the semiconductor light emitting device 10 (referred to as the semiconductor light emitting device 10 unless otherwise distinguished).

A frame 62 is provided on the module substrate 61, and the semiconductor light emitting devices 10A and 10B are mounted inside the frame 62. Side surfaces of the semiconductor light emitting devices 10A and 10B are disposed adjacent to each other. The semiconductor light emitting devices 10A and 10B may be disposed such that side surfaces of the wavelength conversion elements 50 are in contact with each other. In addition, a space between the frame 62 and the semiconductor light emitting devices 10A and 10B is filled with a cover member 63.

The semiconductor light emitting devices 10A and 10B may be light emitting devices having the same light emission color or light emitting devices having different light emission colors. In addition, a protective element may be provided inside the frame 62.

Moreover, since the semiconductor light emitting devices 10A and 10B are shielded by the light shielding film 55, the cover member 63 may not be necessarily provided. When the cover member 63 is provided for the purpose of protection of the semiconductor light emitting devices 10A and 10B or the appearance of the device, a cover member having appropriate properties, such as light transmittance, white color, or black color, can be selected and used.

The module substrate 61 includes an upper wiring layer (first wiring layer) 61A, a buried wiring layer (second wiring layer) 61B, and a module bonding layer 61C provided on a bottom surface of the substrate. In addition, a first terminal 69A and a second terminal 69B (referred to as a terminal 69 unless otherwise distinguished) electrically connected to the semiconductor light emitting devices 10A and 10B are provided on the module substrate 61. The first terminal 69A and the second terminal 69B are, for example, an anode and a cathode, respectively.

Hereinafter, constituent members of the semiconductor light emitting module 60 will be described in detail. As a base material of the module substrate 61, for example, alumina, zirconia, or aluminum nitride can be used. In addition, as a wiring material, for example, silver (Ag), copper (Cu), or tungsten (W) can be used. As the surface wiring material, for example, nickel/gold (Ni/Au) can be used. As the module bonding layer 61C, for example, tungsten/nickel/gold (W/Ni/Au) can be used. When the semiconductor light emitting module 60 is adhered to a heat sink or the wiring substrate with an adhesive, it is not necessary to provide the module bonding layer 61C.

For the frame 62, for example, a silicone resin or an epoxy resin can be used. When the frame 62 is white, for example, titanium oxide particles or alumina particles can be contained in the silicone resin, the epoxy resin, or the like, and when the frame 62 is made black, for example, black titanium oxide, black alumina, carbon black, or the like can be contained. A thickener and a thixotropic agent may be contained.

FIG. 6B is a perspective view illustrating an example of a mounting form of the semiconductor light emitting module 60. The semiconductor light emitting module 60 is mounted on a heat sink 110 using a thermally conductive adhesive 112. In addition, the terminal 69 of the semiconductor light emitting module 60 is connected to wiring 114 of a circuit substrate 113 by ribbon wiring 115.

As described above, the semiconductor light emitting module 60 can be directly mounted on the heat sink with the module substrate 61, and has excellent heat radiation properties. In addition, since the first terminal 69A and the second terminal 69B of the semiconductor light emitting module 60 and the wiring of the circuit substrate 113 can be connected by the ribbon wiring 115 (for example, copper ribbon or gold ribbon), it is also possible to perform heat dissipation by the ribbon wiring 115. In addition, the frame 62, the cover member 63, and the wavelength conversion element 50 can also be protected from a corrosive atmosphere gas by coating the frame 62, the cover member 63, and the wavelength conversion element 50 with a light-transmitting fluororesin.

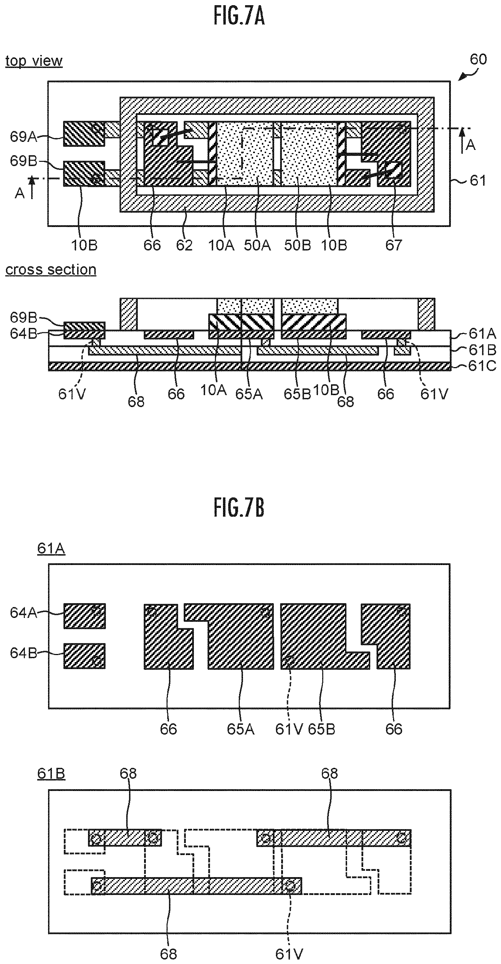

FIG. 7A is a plan view illustrating an internal configuration of the semiconductor light emitting module 60 when viewed from a top, and a cross-sectional view illustrating a cross section taken along the line A-A in the plan view. For ease of description and understanding, the upper and lower parts are shown side by side. In addition, FIG. 7B is a plan view schematically illustrating wiring of two wiring layers of the module substrate 61 (the upper wiring layer 61A and the buried wiring layer 61B). In addition, the cover member is not illustrated.

As illustrated in FIGS. 7A and 7B, the upper wiring layer 61A of the module substrate 61 includes mounting wirings 65A and 65B on which the semiconductor light emitting devices 10A and 10B are mounted, respectively, relay wiring 66, and terminal wirings 64A and 64B.

The anodes 16A of the semiconductor light emitting devices 10A and 10B are connected to the relay wiring 66 by the bonding wires, and the cathodes 16B are connected to the mounting wirings 65A and 65B by the bonding layer. Therefore, the semiconductor light emitting devices 10A and 10B are connected in series between the terminal wirings 64A and 64B. The terminal wirings 64A and 64B are connected to the first terminal 69A and the second terminal 69B, respectively.

A protective element 67 is provided in the semiconductor light emitting module 60. For the protective element 67, for example, a Zener diode, a varistor, or a capacitor can be used.

The module substrate 61 includes a buried wiring layer 61B provided on a lower surface side of the upper wiring layer 61A. The buried wiring layer 61B includes buried wiring 68. The mounting wirings 65A and 65B of the upper wiring layer 61A (referred to as mounting wiring 65 unless otherwise distinguished) and the relay wiring 66 and terminal wirings 64A and 64B are connected to the buried wiring 68 of the buried wiring layer 61B through the via wiring 61V.

With such a configuration, it is possible to provide a semiconductor light emitting module in which the semiconductor light emitting devices 10A and 10B are disposed adjacent to each other or in contact with each other, and light shielding between the semiconductor light emitting devices 10A and 10B is excellent and crosstalk is suppressed.

Moreover, it is possible to provide a semiconductor light emitting module having high contrast of a light output surface without disposing a light-shielding member or the like around the wavelength conversion element. In addition, it is possible to provide a semiconductor light emitting module in which the semiconductor light emitting devices are arranged in a compact manner.

### [Third Embodiment]

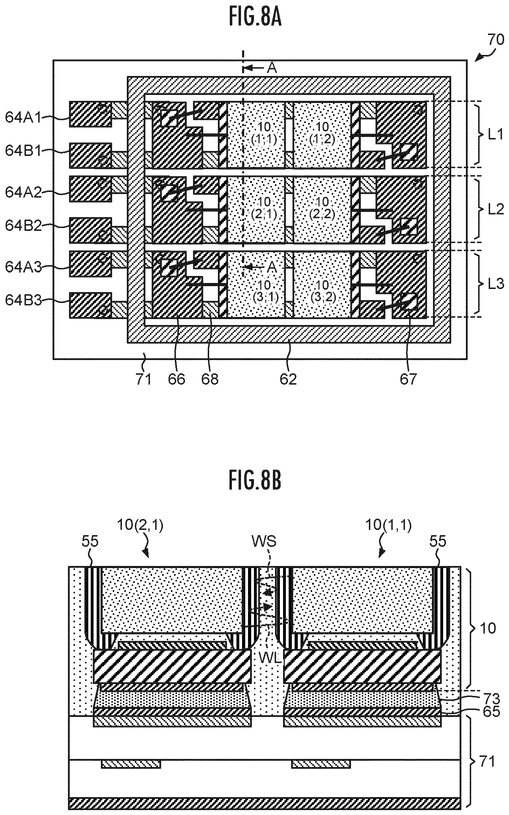

FIG. 8A is a top view (upper part) and a side view (lower part) illustrating an internal structure of a semiconductor light emitting module 70 according to a third embodiment of the present invention.

In the semiconductor light emitting module 60 according to the second embodiment, the semiconductor light emitting devices 10 are disposed in one row and two columns, but in the semiconductor light emitting module 70, the semiconductor light emitting devices 10 are arranged in three rows and two columns. The cover member is not illustrated.

More specifically, the semiconductor light emitting module 70 has the semiconductor light emitting devices 10 (m, n) arranged inside the frame 62 in a matrix (m = 3, n = 2). The semiconductor light emitting devices 10 (1, 1) and 10 (1, 2) are disposed as a first row. A module substrate 71 of the semiconductor light emitting module 70 has the same wiring connection as that of the module substrate 61 of the semiconductor light emitting module 60 provided parallel to three systems and electrically independently of each other.

More specifically, the anodes 16A (not illustrated) of the semiconductor light emitting devices 10 (1, 1) and 10 (1, 2) are connected to the relay wiring 66 by a bonding wire, and the relay wiring 66 is connected to the buried wiring 68. Therefore, the semiconductor light emitting devices 10 (1, 1) and 10 (1, 2) are connected in series between terminal wirings 64A1 and 64B 1. The semiconductor light emitting devices 10 (1, 1) and 10 (1, 2) form a first system L1.

Moreover, the same applies to the semiconductor light emitting devices 10 (2, 1) and 10 (2, 2) of the second row and the semiconductor light emitting devices 10 (3, 1) and 10 (3, 2) of the third row. That is, the semiconductor light emitting devices 10 (2, 1) and 10 (2, 2) of a second system L2 are connected in series between terminal wirings 64A2 and 64B2. In addition, the semiconductor light emitting devices 10 (3,1) and 10 (3,2) of a third system L3 are connected in series between terminal wirings 64A3 and 64B3. That is, the first system L1, the second system L2, and the third system L3 can be independently controlled to emit light.

Therefore, a light emission pattern and an amount of light can be adjusted by controlling energization for each system. In addition, the light emission color can be made different for each system by providing the semiconductor light emitting device 10 having different light emission colors for each system.

FIG. 8B is a cross-sectional view schematically illustrating a cross section taken along the line A-A illustrated in FIG. 8A. That is, FIG. 8B illustrates a cross section across the semiconductor light emitting devices 10 (1, 1) of the first system L1 and the semiconductor light emitting devices 10 (2, 1) of the second system L2 disposed adjacent to each other.

The semiconductor light emitting device 10 (1, 1) and the semiconductor light emitting device 10 (2, 1) are bonded to the mounting wiring 65 via the bonding layer 73 and are disposed adjacent to each other. More specifically, the semiconductor light emitting devices 10 (1, 1) and 10 (2, 1) are disposed close to each other with a narrow gap of 200 µm or less.

The semiconductor light emitting devices 10 (1, 1) and 10 (2, 1) may be disposed with a narrow gap of 20 to 200 µm. Furthermore, electrodes may be disposed in close to each other with a narrow gap of 100 µm or less or a further narrow gap of 50 µm or less or in contact with each other (gap = 0).

In the present specification, the close arrangement refers to a case in which the semiconductor light emitting devices 10 are disposed to be spaced apart from each other with a narrow gap (200 µm or less).

With such a configuration, the light shielding film 55 of the wavelength conversion element 50 prevents light leakage in long wavelength light WL and the short wavelength light WS in the horizontal direction. In addition, it is possible to prevent light leakage due to the adjacent light emitting device emitting pseudo light when the power is supplied to each system.

Moreover, when the semiconductor light emitting devices 10 are disposed adjacent to each other, two light shielding films 55 are disposed between the light-emitting functional layer 20 and the wavelength conversion body 51 of the adjacent semiconductor light emitting devices 10. For example, when the light leakage of one light shielding film is 0.05 (5%), the light leakage is attenuated to 0.0025 (0.25%) by the two light shielding films 55. In addition, by disposing a light-shielding (reflective or absorptive) cover member between the adjacent semiconductor light emitting devices 10, the light leakage can be further reduced.

### [Fourth Embodiment]

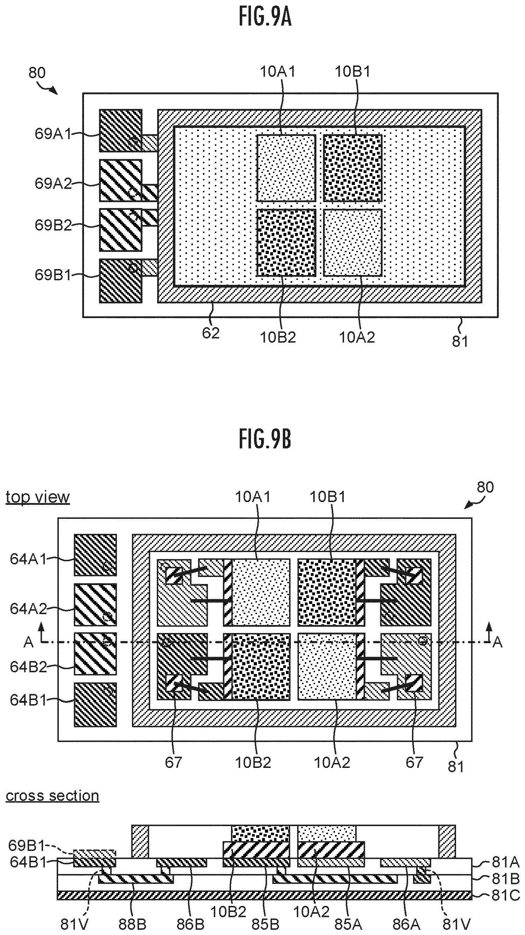

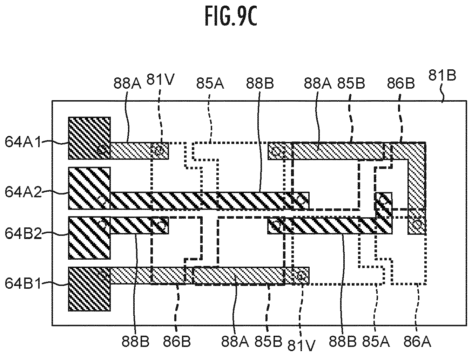

FIG. 9A is a top view illustrating a semiconductor light emitting module 80 according to a fourth embodiment of the present invention. FIG. 9B is a plan view (upper part) illustrating an internal configuration of the semiconductor light emitting module 80 when viewed from a top, and a cross-sectional view (lower part) illustrating a cross section taken along the line A-A in the plan view. In addition, FIG. 9C is a plan view schematically illustrating wirings of an upper wiring layer 81A and a buried wiring layer 81B of the module substrate 81.

Referring to FIGS. 9A and 9B, in the semiconductor light emitting module 80, four semiconductor light emitting devices 10A1, 10B1, 10A2, and 10B2 are provided inside the frame 62 on the module substrate 81. More specifically, the four semiconductor light emitting devices 10A1, 10B1, 10A2, and 10B2 are arranged adjacent to each other in a 2 × 2 matrix.

One pair of semiconductor light emitting devices 10A1 and 10A2 disposed at diagonal positions emits a first light emission color, for example, white light, and the other pair of semiconductor light emitting devices 10B1 and 10B2 disposed at diagonal positions emits a second light emission color, for example, amber (orange) light.

The semiconductor light emitting devices 10A1 and 10A2 (semiconductor light emitting devices of the first light emission color) are mounted on mounting wiring 85A. The anodes 16A of the semiconductor light emitting devices 10A1 and 10A2 are connected to relay wiring 86A by a bonding wire, and the cathode 16B is connected to the mounting wiring 85A by a bonding layer.

The same applies to the other pair of the semiconductor light emitting devices 10B1 and 10B2 (semiconductor light emitting devices of the second light emission color), and the semiconductor light emitting devices 10B1 and 10B2 are mounted on the mounting wiring 85B, the anode 16A is connected to the relay wiring 86B by a bonding wire, and the cathode 16B is connected to the mounting wiring 85B by the bonding layer.

As illustrated in FIG. 9B, the first to fourth terminals 69A1, 69B1, 69A2, and 69B2 (indicated by broken lines) of the semiconductor light emitting module 80 are provided on the terminal wirings 64A1, 64B1, 64A2, and 64B2 of the upper wiring layer 81A.

FIG. 9C is a view illustrating buried wirings 88A and 88B of a buried wiring layer 81B of the module substrate 81. FIG. 9C illustrates that mounting wirings 85A and 85B and the relay wirings 86A and 86B (dashed lines) of the upper wiring layer 81A are superimposed on each other such that a positional relationship with the wiring of the upper wiring layer 81A is easy to understand.

The mounting wirings 85A and 85B and the relay wirings 86A and 86B of the upper wiring layer 81A and the terminal wirings 64A1, 64B1, 64A2, and 64B2 are connected to the buried wirings 88A and 88B of the buried wiring layer 81B via the via wiring 81V.

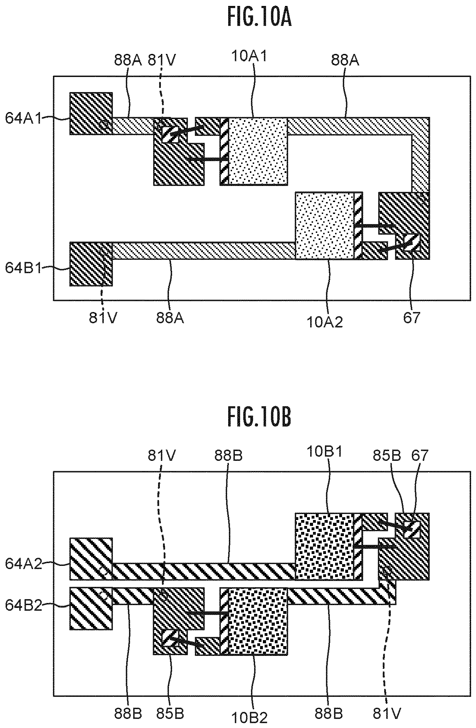

FIGS. 10A and 10B are views schematically illustrating a connection form of the semiconductor light emitting devices 10A1 and 10A2 and a connection form of the semiconductor light emitting devices 10B1 and 10B2 in a separated manner, for ease of understanding.

As illustrated in FIG. 10A, one pair of semiconductor light emitting devices 10A1 and 10A2 are connected in series between the terminal wirings 64A1 and 64B1 by the buried wiring 88A. Therefore, the semiconductor light emitting devices 10A1 and 10A2 form a connection circuit of the first system.

Moreover, as illustrated in FIG. 10B, the other pair of the semiconductor light emitting devices 10B1 and 10B2 are connected in series between the terminal wirings 64A2 and 64B2 by the buried wiring 88B. Therefore, the semiconductor light emitting devices 10B1 and 10B2 form a connection circuit of the second system.

The connection circuit of the first system, which is a system of the first light emission color is electrically separated from the connection circuit of the second system, which is a system of the second light emission color, and can be independently controlled to emit light.

With the semiconductor light emitting module 80 according to the present embodiment, the same advantages as those of the semiconductor light emitting modules of the second and third embodiments described above can be obtained. That is, the plurality of light emitting devices can be disposed and mounted close to each other and in contact with each other, and the light shielding between the light emitting devices is excellent, and the light leakage due to the pseudo light emission of the adjacent semiconductor light emitting device 10 can be prevented.

Furthermore, with the semiconductor light emitting module 80 according to the present embodiment, the plurality of semiconductor light emitting devices having one light emission color and the plurality of semiconductor light emitting devices having a different light emission color can be cross-disposed, that is, disposed in a checkered pattern. That is, even in a case where the semiconductor light emitting devices are disposed in this manner, it is possible to provide a semiconductor light emitting module in which light shielding between the light emitting devices is excellent and deviation in light emission color of each semiconductor light emitting device is suppressed.

As described in detail above, according to the present invention, it is possible to provide a light emitting device having high performance of shielding emitted light from a light emitting element and emitted light from a wavelength conversion member without providing individual cover members on side surfaces of the light emitting element. In addition, it is possible to provide a light emitting module in which a plurality of light emitting devices can be disposed close to each other and in contact with each other, and which has excellent light shielding between the light emitting devices and suppressed crosstalk.

### Description of Reference Numerals

- 10, 10A, 10B, 10(m,n), 10A1, 10B1, 10A2, 10B2: semiconductor light emitting device
- 11: light emitting element
- 12: wiring substrate
- 12A: support substrate
- 14: interlayer insulating film
- 15: substrate protective film
- 16: p-wiring electrode
- 16A: anode
- 16B: cathode
- 18B: n-wiring electrode
- 20: light-emitting functional layer
- 21: n-type semiconductor layer
- 22: light emitting layer
- 23: p-type semiconductor layer
- 25A: p-electrode
- 25B: n-electrode
- 26V: via
- 50: light-transmitting optical element
- 51: light-transmitting optical body
- 55: light shielding film
- 55R: rim portion
- 60, 70, 80: semiconductor light emitting module
- 61, 71, 81: module substrate
- 61A, 81A: upper wiring layer
- 61B, 81B: buried wiring layer
- 61V, 81V: via wiring
- 62: frame
- 63: cover member
- 64, 64A, 64B, 64A1, 64B1, 64A2, 64B2: terminal wiring
- 65, 65A, 65B, 85A, 85B: mounting wiring
- 66, 86A, 86B: relay wiring
- 67: protective element
- 68, 88A, 88B: buried wiring
- 69A, 69B, 69A1, 69B1, 69A2, 69B2: terminal

## Claims

1. A semiconductor light emitting device comprising:
a wiring substrate on which a p-electrode and an n-electrode are provided on a substrate;
a light-emitting functional layer including a p-type semiconductor layer connected to the p-electrode, a light emitting layer, and an n-type semiconductor layer connected to the n-electrode, and bonded onto the wiring substrate;
a light-transmitting optical element having a light shielding film provided on a side surface of a plate-shaped light-transmitting optical body and which has an annular frame portion that covers a peripheral edge portion of a back surface of the light-transmitting optical body and formed on the peripheral edge portion; and
an adhesive layer configured to adhere the light-transmitting optical element to an upper surface of the wiring substrate such that the light-emitting functional layer is inserted into a recessed portion inside the frame portion,
wherein the recessed portion is filled with the adhesive layer.

2. The semiconductor light emitting device according to claim 1,
wherein at least one of the p-electrode and the n-electrode is provided on a surface of the wiring substrate to which the light-transmitting optical element is adhered.

3. The semiconductor light emitting device according to claim 1 or 2,
wherein at least a part of the frame portion of the light shielding film is in contact with the upper surface of the wiring substrate.

4. The semiconductor light emitting device according to any one of claims 1 to 3,
wherein the light shielding film is provided over an entire side surface of the light-transmitting optical body.

5. The semiconductor light emitting device according to any one of claims 1 to 4,
wherein at least a part of a side surface of the light-transmitting optical element protrudes from a side surface of the wiring substrate.

6. The semiconductor light emitting device according to any one of claims 1 to 4,
wherein the light-transmitting optical element has a rectangular shape, and three side surfaces of the light-transmitting optical element protrude from a side surface of the wiring substrate.

7. The semiconductor light emitting device according to any one of claims 1 to 4,
wherein the light-emitting functional layer has a reflective layer on a surface close to the wiring substrate.

8. The semiconductor light emitting device according to any one of claims 1 to 7,
wherein the light-transmitting optical element is a wavelength conversion element.

9. A semiconductor light emitting module comprising:
a plurality of the semiconductor light emitting devices according to any one of claims 1 to 8,
wherein two of the semiconductor light emitting devices are provided such that side surfaces of the light-transmitting optical elements are disposed adjacent to each other.

10. The semiconductor light emitting module according to claim 9,
wherein the two semiconductor light emitting devices are provided such that side surfaces of the light-transmitting optical elements are disposed in contact with each other.

11. The semiconductor light emitting module according to claim 9 or 10,
wherein the two semiconductor light emitting devices have different light emission colors from each other.

12. A semiconductor light emitting module comprising:
a plurality of the semiconductor light emitting devices according to any one of claims 1 to 8, and
a plurality of series connection systems, each of the series connection systems including two of the semiconductor light emitting devices having side surfaces of the light-transmitting optical elements disposed adjacent to each other and connected in series.

13. The semiconductor light emitting module according to claim 12,
wherein the plurality of series connection systems is disposed such that the semiconductor light emitting devices of the plurality of series connection systems are arranged adjacent to each other in a matrix.

14. The semiconductor light emitting module according to claim 12 or 13,
wherein the plurality of series connection systems has different light emission colors for each connection system.

15. A semiconductor light emitting module comprising:
a plurality of the semiconductor light emitting devices according to any one of claims 1 to 8, and
two series connection systems connected in series, respectively, wherein four semiconductor light emitting devices are arranged in a 2 × 2 matrix, and one pair of the semiconductor light emitting devices are disposed at a diagonal position and the other pair of the semiconductor light emitting devices are disposed at a diagonal position.

16. The semiconductor light emitting module according to claim 15,
wherein the two series connection systems have different light emission colors from each other.
